Europäisches Patentamt

European Patent Office

Office européen des brevets

(11) Veröffentlichungsnummer: **0 243 733 B1**

(12) **EUROPÄISCHE PATENTSCHRIFT**

(45) Veröffentlichungstag der Patentschrift: **04.03.92**

(21) Anmeldenummer: **87105025.8**

(22) Anmeldetag: **04.04.87**

(51) Int. Cl.⁵: **H03D 7/00**, H03G 3/20

(54) **Verfahren zur Regelung eines Einseitenband-Aufwärtsmischers sowie Anordnung hierzu.**

(30) Priorität: **22.04.86 DE 3613536**

(43) Veröffentlichungstag der Anmeldung:
**04.11.87 Patentblatt 87/45**

(45) Bekanntmachung des Hinweises auf die
Patenterteilung:
**04.03.92 Patentblatt 92/10**

(84) Benannte Vertragsstaaten:
**AT CH DE FR GB LI NL**

(56) Entgegenhaltungen:
**EP-A- 0 119 439**
**DE-C- 3 344 318**
**GB-A- 2 117 589**

(73) Patentinhaber: **ANT Nachrichtentechnik GmbH**
**Gerberstrasse 33**
**W-7150 Backnang(DE)**

(72) Erfinder: **Schiller, Wolfgang, Dipl.-Ing.**
**Samtrotweg 4**
**W-7101 Flein(DE)**

EP 0 243 733 B1

**Beschreibung**

Die Erfindung betrifft ein Verfahren zur Regelung eines Einseitenband-Aufwärtsmischers gemäß dem Oberbegriff des Patentanspruchs 1 sowie eine Anordnung hierzu.

Bei Einseitenband-Aufwärtsmischern ist oft eine hohe Störlinienunterdrückung gefordert, insbesondere bei Funkgeräten, die höherwertige digitale Modulationsarten verwenden, wie z.B. 64 QAM (Quadraturamplitudenmodulation) und 256 QAM. Früher wurde das unerwünschte Seitenbandsignal durch einen auf den RF-Kanal abgestimmten mehrkreisigen Bandpaß ausgesiebt (ANT Nachrichtentechnische Berichte, Heft 2, Dezember 1985, Seite 27). Dies ist heutzutage durch die Verwendung von Einseitenbandmischern mit Steuerung der Oszillatorunterdrückung über PROMs und D/A-Wandler (ANT Nachrichtentechnische Berichte, Heft 2, Dezember 1985, Seiten 27 bis 29; EP 119 439 A2) nicht mehr erforderlich.

Aufgabe der Erfindung ist es ausgehend vom Oberbegriff des Patentanspruchs 1 ein Verfahren anzugeben, welches eine gute Störlinienunterdrückung bei breitbandiger Durchstimmbarkeit über der Frequenz ermöglicht und außerdem Änderungen, wie sie z.B. durch Alterung, Frequenzgang, Temperatur und Pegeländerungen auftreten, ausgleichen kann. Außerdem soll eine Anordnung zum Durchführen dieses Verfahrens angegeben werden.

Diese Aufgabe wird bezüglich des Verfahrens durch die Merkmale des Patentanspruchs 1 gelöst. In den Ansprüchen 2 bis 4 sind vorteilhafte Weiterbildungen des Verfahrens aufgezeigt. Anspruch 5 betrifft eine Anordnung zum Durchführen des Verfahrens.

Die Erfindung ermöglicht die Ausregelung von Änderungen - Alterung, Frequenzgang, Temperatur und Pegeländerungen - bei gleichzeitig hoher Störlinienunterdrückung und breitbandiger Durchstimmbarkeit. Bei dem Einseitenbandmischer gemäß EP-A-119 439 ist zwar eine Oszillatorunterdrückung und eine breitbandige Durchstimmbarkeit gegeben, jedoch ist die Spiegelfrequenzunterdrückung nicht hinreichend groß und Änderungen, wie sie z.B. durch Alterung, Frequenzgang, Temperatur und Pegeländerungen auftreten, können nicht erfaßt werden. Bei einem Standard-Einseitenbandmischer mit nachgeschaltetem Seitenbandfilter ist kein Frequenzwechsel ohne Filtertausch möglich. An ein solches Seitenbandfilter sind außerdem sehr hohe Anforderungen bezüglich Frequenzgang und Laufzeit zu stellen. Bei einem herkömmlichen Einseitenbandmischer läßt sich die Störlinienunterdrückung zwar für eine feste Betriebsfrequenz einstellen und optimieren, jedoch können besagte Änderungen nicht berücksichtigt werden. Für jeden Frequenzwechsel muß eine erneute Einstellung und Optimierung vorgenommen werden.

Aufgrund der erfindungsgemäßen Rückmischung des Mischerausgangssignals läßt sich die Oszillatorunterdrückung und das unerwünschte Seitenband (Spiegelfrequenz) unter einen bestimmten Wert, z.B. -35 bis -40 dB, regeln. Der Vorteil der Erfindung liegt in der Verwendung des Radiofrequenzsignals als Oszillatorfrequenz zur Rückmischung der Störsignale im Gegensatz zur Verwendung des Oszillatorsignals für die Mischstufen bei einem herkömmlichen Mischer, beispielsweise gemäß DE-A-33 44 318.

Es ist hier auch noch auf das Dokument GB-A-2 117 589 zu verweisen, bei dem in einem SSB System ebenfalls eine Rückmischung zum Zwecke einer Steuerung stattfindet. Die dortige Steuerung wirkt jedoch nicht auf den oder die Mischer, sondern, da der dort beschriebene Sender nach dem "polar loop" - Prinzip arbeitet, auf zwei getrennte Amplituden- und Phasenzweige ein. Dieses Dokument gibt ferner nicht an, ob auf die Zwischenfrequenz rückgemischt wird. Es bestehen somit grundlegende Unterschiede zum vorliegenden System.

Anhand der Zeichnungen wird die Erfindung nun näher erläutert. Es zeigen

Fig. 1 ein Prinzipschaltbild eines Einseitenband-Aufwärtsmischers zum Durchführen des Verfahrens,

Fig. 2 die Gewinnung der Steuersignale mittels eines Mikrocomputers,

Fig. 3 ein Flußdiagramm für die Signalverarbeitung durch den Mikrocomputer,

Fig. 4 den Stromlaufplan des Zwischenfrequenzkreises.

Fig. 5 den Aufbau der Aufwärts-Mischstufen,

Fig. 6 den Aufbau des Rückmischers,

Fig. 7 das Ausgangssignalspektrum eines herkömmlichen Einseitenband-Aufwärtsmischers und

Fig. 8 das Ausgangssignalspektrum des Einseitenband-Aufwärtsmischers der Erfindung.

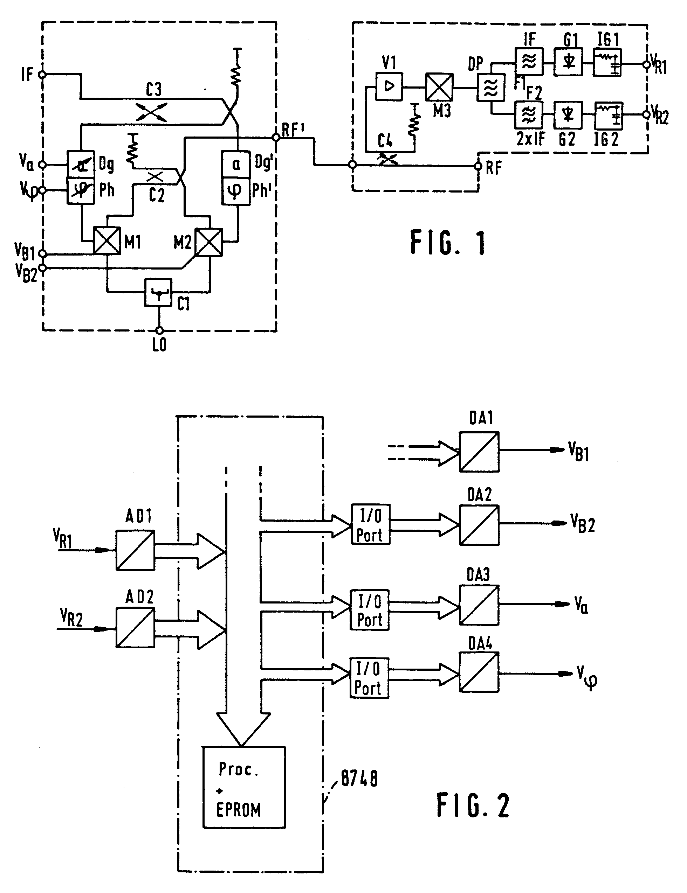

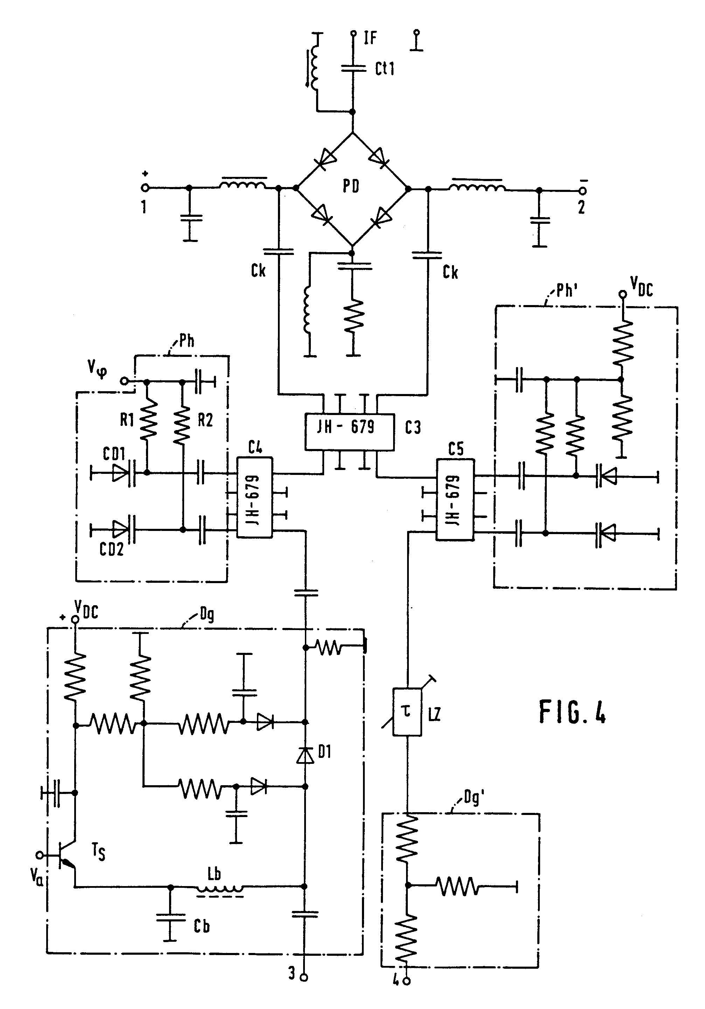

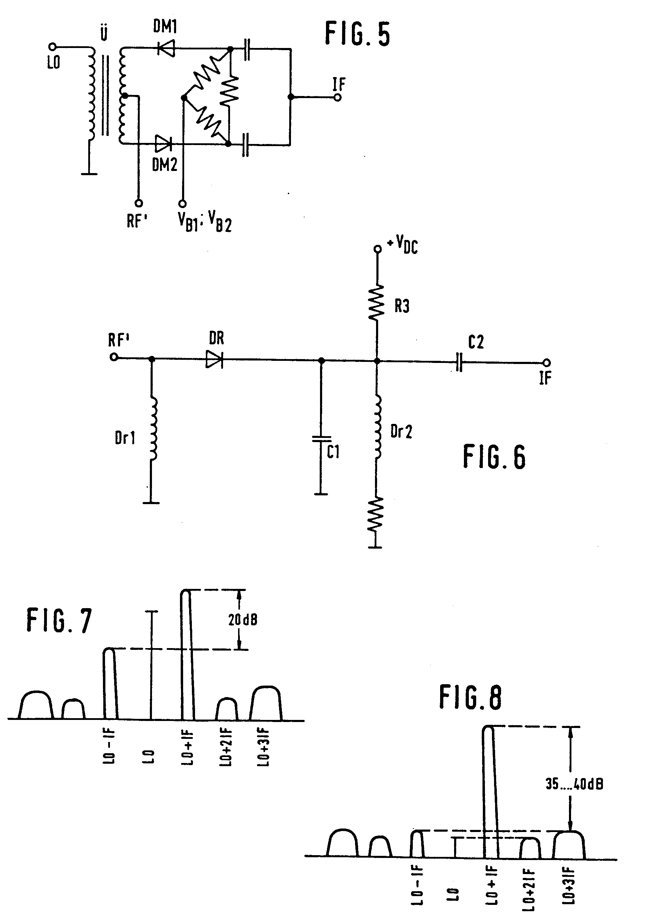

Das Prinzipschaltbild des Einseitenband-Aufwärtsmischers nach der Erfindung zeigt Fig. 1. Der Zwischenfrequenzkreis dieses Aufwärtsmischers besteht aus zwei Mischstufen (Balanced mixers) M1 und M2. Die umzusetzende Frequenz IF wird über den 3 dB/90°-Koppler C3, jeweils über ein Dämpfungsglied Dg, Dg' und einen Phasenschieber Ph, Ph' zu einer der Mischstufen M1 bzw. M2 geführt. Über die Signalverzweigung C1 wird die vorwählbare Ozillatorfrequenz LO zu den beiden Mischstufen M1 und M2 geführt. Die Ausgänge der Mischstufen M1 und M2 sind auf den 3 dB/90°-Koppler C2 geschaltet, an dessen einem Ausgang die Radiofrequenz RF' - Mischerausgangssignal - abnehmbar ist. Ein geringer Teil der Radiofrequenz RF' wird über den Koppler C4 ausgekoppelt. Die ausgekoppelte Radiofrequenz RF' wird bei Bedarf in einer Verstärkerstufe V1 verstärkt. Das evtl. verstärkte Signal steuert einen Rückmischer M3. Somit dient die Radiofrequenz RF' als Oszillatorfrequenz für den Rückmischer M3, der als Eintaktmischer ausgebildet ist. Die unerwünschten Störsignale (unerwünschtes Seitenband; Oszillatorfrequenz LO für die beiden Mischstufen M1 und M2) werden mittels des Rückmischers M3 in die Zwischenfrequenzlage umgesetzt. Das Ausgangssignal des Rückmischers M3 gelangt über einen Diplexer DP zu einem Filter F1 für die Zwischenfrequenz IF und einem Filter F2 für die 1. Harmonische, d.h. die doppelte Zwischenfrequenz 2xIF. Diese ausgefilterten Signale werden mittels der Gleichrichter G1 und G2 gleichgerichtet, gegebenenfalls verstärkt und mittels der Integrationsglieder IG1 und IG2 integriert. Die an den Ausgängen anstehenden Spannungen $V_{R1}$ und $V_{R2}$ sind ein Maß für die Oszillatorunterdrückung und Seitenbandunterdrückung des Mischers. Die Spannungen $V_{R1}$ und $V_{R2}$ werden einem Mikrocomputer MC mit Interface-Schaltungen (Fig. 2) zugeführt, um Steuersignale $V_{B1}$ und $V_{B2}$ für die Mischstufen M1 und M2 sowie Steuersignale $V_a$ und $V_\phi$ für ein steuerbares Dämpfungsglied Dg und einen steuerbaren Phasenschieber Ph zu erzeugen. Das steuerbare Dämpfungsglied Dg und der steuerbare Phasenschieber Ph befinden sich im Zwischenfrequenzzweig zwischen Koppler C3 und Mischer M1, wohingegen im Zweig zwischen Koppler C3 und Mischer M2 ein fest eingestelltes Dämpfungsglied Dg' und ein fest eingestellter Phasenschieber Ph' angeordnet ist, Die Steuersignale $V_{B1}$ und $V_{B2}$ werden den Mischerdioden der Mischstufen M1 und M2 (Fig. 5) als Steuergleichspannungen zur Unterdrückung der Oszillatorfrequenz LO zugeführt. Die Steuersignale $V_\phi$ und $V_a$ dienen zur Einstellung der Phase des Phasenschiebers Ph und zur Einstellung der Dämpfung des Dämpfungsgliedes Dg. Der genaue Aufbau dieser Baugruppen wird im Zusammenhang mit Fig. 4 beschrieben. Um eine quasi-vollständige Seitenbandunterdrückung erreichen zu können und alle Phasen- und Amplitudenfehler des Mischers kompensieren zu können, ist eine elektronische Durchstimmbarkeit des Phasenschiebers Ph von ± 20° erforderlich und eine elektronische Durchstimmbarkeit des Dämpfungsgliedes Dg von ± 1,5 dB.

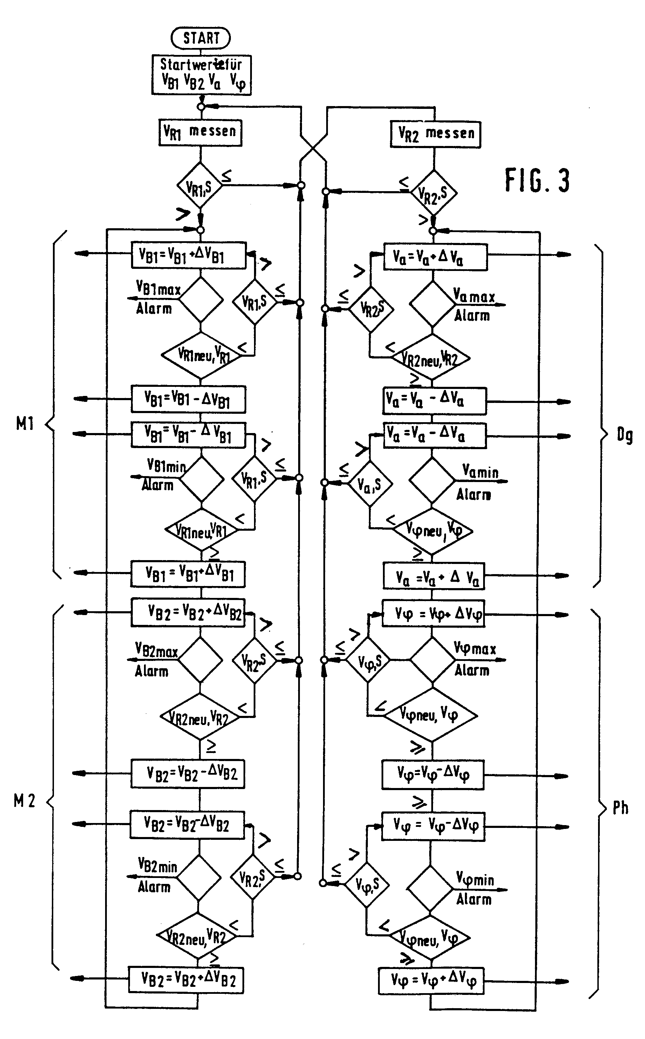

Den prinzipiellen Aufbau des Mikrocomputers mit Interface-Schaltungen zeigt Fig. 2. Die Spannungen $V_{R1}$ und $V_{R2}$ vom Rückmischer werden jeweils A/D-Wandlern AD1 und AD2 zugeführt. Für die A/D-Wandler können beispielsweise die integrierten Bausteine ADC 0804 verwendet werden. Die A/D gewandelten Signale werden dem Bus eines Mikrocomputers zugeführt. Als Mikrocomputer eignet sich ein 8748 von Intel. Die Signalverarbeitung in diesem Mikrocomputer erfolgt gemäß dem Flußdiagramm in Fig. 3. Zuerst werden Startwerte $V_{B1}$, $V_{B2}$, $V_a$ und $V_\phi$ vorgegeben. Diese werden so gewählt, daß die entsprechenden Regelspannungen bezüglich $V_{B1}$ und $V_{B2}$ O sind. Für $V_a$ und $V_\phi$ werden andere Startwerte vorgegeben. Nach Messung der Werte für $V_{R1}$ und $V_{R2}$ erfolgt der Vergleich mit einem Schwellwert S. Dieser Schwellwert S wird zu -35 bis -40 dB angenommen. Wie das Flußdiagramm zeigt, wird zur Ermittlung eines neuen Rechenwertes immer ein $\Delta$-Wert ($\Delta V_{B1}$, $\Delta V_{B2}$, $\Delta V_a$, $\Delta V_\phi$) addiert, bzw. subtrahiert und erneut verglichen. Diese $\Delta$-Werte können bei einem Wertevorrat von beispielsweise 256 Binärstufen gerade einer Binärstufe entsprechen. Falls der Vergleich in einer entsprechenden Entscheidungsschleife des Flußdiagramms keine Abweichung mehr erbringt, wird der zuletzt berechnete Wert als 8 Bit breites Wort an einen I/O-Port weitergegeben. Für die I/O-Ports können die Bausteine 8255A von Intel verwendet werden. Bei Überschreitung des Wertebereichs wird über entsprechende Ausgänge Alarm gemeldet. An die I/O-Ports sind D/A-Wandler DA1 bis DA4, beispielsweise 1408, angeschlossen. Über gegebenenfalls erforderliche Operationsverstärker, z.B. 4741, sind die Steuerspannungen $V_{B1}$, $V_{B2}$, $V_a$, $V_\phi$ abgreifbar.

Der Stromlaufplan des Zwischenfrequenzkreises ist in Fig. 4 dargestellt. Die Zwischenfrequenz IF wird über einen Gleichstromtrennkondensator Ct1 auf eine Diodenbrücke PD, bestehend aus 4 Pin-Dioden geführt. Jeweils ein Zweig der Pin-Dioden-Brücke PD ist über einen Eingang 1, bzw. 2, schaltbar. Durch die Ansteuerung des Eingangs 1 mit einem positiven Potential, bzw. des Eingangs 2 mit einem negativen Potential, ist die Auswahl des zu unterdrückenden Seitenbandes (LSB/USB) möglich. Über Koppelkondensatoren Ck sind die beiden Ausgänge der Pin-Dioden-Brücke PD an die Eingänge des 3 dB/90°-Kopplers C3 angeschlossen. Die beiden Ausgänge dieses Kopplers führen zu jeweils einem der Phasenschieber Ph, Ph'. Der Phasenschieber Ph ist durch das Steuersignal $V_\phi$ in seiner Phase einstellbar, wohingegen der Phasenschieber Ph, durch die Spannung $V_{DC}$ fest eingestellt ist. Die Steuerung des Phasenschiebers Ph erfolgt durch Ändern der Vorspannung der beiden Kapazitätsdioden CD1 und CD2 in Abhängigkeit der Steuerspannung $V_\phi$ über die Widerstände R1 und R2. Der Phasenschieber Ph' ist gleich aufgebaut. Die Einbindung der beiden Phasenschieber in den Zwischenfrequenzkreis erfolgt ebenfalls über 3 dB/90°-Koppler. Für diese 3 dB/90°-Koppler können beispielsweise für eine Zwischenfrequenz $f_{ZF}$ = 140 MHz JH-679 Bausteine verwendet werden. Das steuerbare Dämpfungsglied Dg besteht aus einer Transistorstufe Ts, deren Basis mit dem

Steuersignal $V_a$ beaufschlagt ist. Im Längszweig des steuerbaren Dämpfungsgliedes Dg, d.h. zwischen Ausgang des steuerbaren Phasenschiebers Ph und Eingang der Mischstufe M1 befindet sich eine Diode D1. Anode und Katode dieser Diode D1 sind jeweils über ein RC-Glied und eine weitere Diode an den Kollektor der Transistorstufe Ts sowie an eine Versorgungsgleichspannung $V_{DC}$ angeschlossen. Der Emitter der Transistorstufe Ts ist über HF-Abblockungsglied Cb, Lb an die Anode der Diode D1 angeschlossen. Das feste Dämpfungsglied Dg' zwischen Phasenschieber Ph' und Mischstufe M2 besteht aus einem Widerstands-T-Glied. Zum Ausgleich eventueller Laufzeitunterschiede in den beiden Zwischenfrequenzzweigen ist diesem T-Glied ein einstellbares Laufzeitglied LZ vorgeschaltet. An den Ausgängen 3 und 4 sind die Zwischenfrequenzsignale $IF1_{out}$ und $IF2_{out}$ zur Ansteuerung der Mischstufen M1 und M2 verfügbar.

Der Aufbau der Mischstufen M1 und M2 ist in Fig. 5 dargestellt. Die Oszillatorfrequenz LO wird in einem Übertrager Ü primärseitig eingespeist. Die Wicklungsenden der Sekundärwicklung des Übertragers Ü sind mit den Mischerdioden DM1 und DM2 verbunden und zwar das eine Ende mit einer Katode und das andere Ende mit einer Anode einer Mischerdiode. Die dem Übertrager Ü abgewandten Enden der Mischerdioden sind über Gleichspannungsabtrennkondensatoren miteinander verbunden. An diesem Verbindungspunkt wird die umzusetzende Frequenz IF - $IF1_{out}$, $IF2_{out}$ - eingespeist. Die Steuergleichspannung $V_{B1}$ bzw. $V_{B2}$ wird jeder Mischstufe über eine Widerstanddreieckschaltung zugeführt. Zwei Ecken der Dreiecksschaltung sind jeweils an den Verbindungspunkten zwischen den Mischerdioden DM1 und DM2 und den Gleichspannungsabtrennkondensatoren angeschlossen. An der dritten Ecke der Dreiecksschaltung wird die Steuergleichspannung $V_{B1}$ bzw. $V_{B2}$ zugeführt. Die Radiofrequenz RF' kann am Mittelabgriff der Sekundärwicklung des Übertragers Ü abgenommen werden. Als Mischerdioden eignen sich vorzugsweise High Barrier Silizium Schottky-Dioden. Pro Gegentaktmischer wird jeweils eine Diode durch die Steuerspannung $V_{B1}$ bzw. $V_{B2}$ soweit vorgespannt, daß ein Strom von 0 bis max. 3 mA fließt.

Als Rückmischer M3 wird, wie die Fig. 6 zeigt, ein Eintaktmischer eingesetzt, der zweckmäßigerweise aus einer halben Mischstufe M1 oder M2 besteht. Es ist mit nur einer Rückmischdiode DR aufgebaut. Die Radiofrequenz RF' wird direkt auf die Anode der Mischdiode geführt. Die Drossel Dr1 auf der Radiofrequenzseite stellt einen Leerlauf für die Radiofrequenz RF' dar. Die Drossel Dr2 sperrt ZF-Spannung im Gleichstromweg. Der Kondensator C1 stellt einen Kurzschluß für die Radiofrequenz dar. Eine feste Vorspannung für die Rückmischdiode DR wird über den Widerstand R3 zugeführt.

In Fig. 7 ist das Ausgangssignalspektrum eines herkömmlichen QAM modulierten Einseitenbandmischers dargestellt. Das gewünschte Seitenband LO + IF ragt nur wenig über den Pegel der unerwünschten Oszillatorfrequenz LO. Das unerwünschte Seitenband LO-IF ist um 20 dB abgesenkt.

Fig. 8 zeigt das Ausgangssignalspektrum eines QAM modulierten Einseitenbandmischers nach der Erfindung. Die unerwünschten Seitenbänder LO-IF, LO + ZIF, ... sind um 35 bis 40 dB gegenüber dem erwünschten Seitenband LO + IF abgesenkt.

Eine breitbandige Durchstimmbarkeit des Mischers über der Frequenz ist gegeben; hierzu ist nur die Oszillatorfrequenz LO zu ändern ohne irgendeine Filter- oder Kreisnachstimmung. Änderungen über Temperatur, Alterung Pegeländerungen und Frequenzgang werden ausgeregelt. Der Mikrocomputer ersetzt ein aufwendiges Analog-Regelsystem. Die geforderten Störsignalabstände von 20 dB für 16 QAM, 28 dB für 64 QAM und 36 dB für 256 QAM werden erfüllt bzw. bei weitem übertroffen.

## Patentansprüche

1. Verfahren zur Regelung eines Einseitenband-Aufwärtsmischers mit zwei Mischstufen (M1, M2), denen eine vorwählbare Oszillatorfrequenz (LO) und eine umzusetzende Frequenz (IF) zugeführt wird, wobei jeder Mischstufe (M1, M2) zum Ausgleich parasitärer Einflüsse Steuersignale zugeführt werden, dadurch gekennzeichnet, daß ein Teil des Mischerausgangssignals (RF') einem Rückmischer (M3) zugeführt wird, daß aus dem rückgemischten Signal die ursprüngliche Zwischenfrequenz sowie mindestens ein Vielfaches derselben als Maß für die Oszillator- und Seitenbandunterdrückung ausgefiltert wird, und daß aus diesen ausgefilterten Signalen die Steuersignale ($V_{B1}$, $V_{B2}$) für die Mischstufen (M1, M2) gewonnen werden.

2. Verfahren nach Anspruch 1, dadurch gekennzeichnet, daß aus der rückgemischten ausgefilterten Zwischenfrequenz sowie aus der ausgefilterten doppelten Zwischenfrequenz Steuersignale ($V_a$, $V_\phi$) für einen steuerbaren Phasenschieber (Ph) und ein steuerbares Dämpfungsglied (Dg) im Zwischenfrequenzkreis des Aufwärtsmischers gewonnen werden.

3. Verfahren nach Anspruch 1 oder 2, dadurch gekennzeichnet, daß die Steuerspannungen ($V_{B1}$, $V_{B2}$, $V_a$, $V_\phi$) aus den rückgemischten und ausgefilterten Signalen mittels eines Mikrocomputers (MC) gewonnen werden.

**4.** Verfahren nach einem der Ansprüche 1 bis 3, dadurch gekennzeichnet, daß die umzusetzende Frequenz (IF) über eine Pindioden-Brückenschaltung (PD) in den Zwischenfrequenzkreis eingekoppelt wird zur Auswahl des zu unterdrückenden Seitenbandes.

**5.** Anordnung zum Durchführen des Verfahrens nach einem der Ansprüche 1 bis 4 zur Regelung eines Einseitenband-Aufwärtsmischers, bestehend aus zwei Mischstufen (M1, M2) und Mitteln zum Zuführen der umzusetzenden Frequenz (IF) und der Oszillatorfrequenz (LO), dadurch gekennzeichnet, daß am Mischerausgang Auskopplungsmittel (C4) vorgesehen sind, daß diese Auskopplungsmittel (C4) mit einem Rückmischer (M3) verbunden sind, daß der Ausgang des Rückmischers (M3) mit Filtern (F1, F2) für die Zwischenfrequenz (IF) sowie die doppelte Zwischenfrequenz (2xIF) verbunden ist, daß diesen Filtern (F1, F2) Gleichrichter (G1, G2) nachgeschaltet sind, daß die Gleichrichterausgänge zu einem Mikrocomputer (MC) führen, daß Ausgänge des Mikrocomputers (MC) an Steuereingänge der Mischstufen (M1, M2) und an Steuereingänge mindestens eines steuerbaren Phasenschiebers (Ph) und/oder Dämpfungsgliedes (Dg) im Zwischenfrequenzkreis des Aufwärtsmischers führen.

**Claims**

**1.** A method of regulating a single sideband up converter having two mixer stages (M1, M2), to which is supplied a preselected oscillator frequency (LO) and a frequency (IF) to be converted, with each mixer stage (M1, M2) receiving control signals to compensate for parasitic influences, characterised in that part of the converter output signal (RF') is fed to a down converter (M3); the original intermediate frequency and at least a multiple of the same is filtered out of the down converted signal as a measure of the oscillator and sideband suppression; and the control signals ($V_{B1}$ and $V_{B2}$) for the mixer stages (M1, M2) are obtained from these filtered-out signals.

**2.** A method according to claim 1, characterised in that control signals ($V_a$, $V_\phi$) for a controllable phase shifter (Ph) and a controllable damping member (Dg) in the intermediate frequency circuit of the up converter are obtained from the down converted, filtered-out intermediate frequency and from the filtered-out double intermediate frequency.

**3.** A method according to claim 1 or 2, characterised in that the control voltages, ($V_{B1}$, $V_{B2}$, $V_a$, $V_\phi$) are obtained from the down converted and filtered out signals by means of a microcomputer (MC).

**4.** A method according to one of claims 1 to 3, characterised in that, for the selection of the sideband to be suppressed, the frequency (IF) to be converted is coupled via a PIN diode bridge circuit (PD) into the intermediate frequency circuit.

**5.** An arrangement for implementing the method defined in one of claims 1 to 4 for regulating a single sideband up converter, comprising two mixer stages (M1, M2) and means for supplying the frequency (IF) to be converted and the oscillator frequency (LO), characterised in that coupling means (C4) are provided at the mixer output; these coupling means (C4) are connected with a down converter (M3); the output of the down converter (M3) is connected with filters (F1, F2) for the intermediate frequency (IF) and for the double intermediate frequency (2xIF); rectifiers (G1, G2) are connected in series with these filters (F1, F2); the rectifier outputs lead to a microcomputer (MC); outputs of the microcomputer (MC) lead to control inputs of the mixer stages (M1, M2) and to control inputs of at least one controllable phase shifter (Ph) and/or damping member (Dg) in the intermediate frequency circuit of the up converter.

**Revendications**

**1.** Procédé de régulation d'un mélangeur élévateur à bande latérale unique avec deux étages mélangeurs (M1, M2) auxquels est appliquée une fréquence d'oscillateur présélectionnable (LO) et une fréquence à convertir (IF), des signaux de commande étant appliqués à chaque étage mélangeur (M1, M2) pour compenser des influences parasites, caractérisé par le fait qu'une partie du signal de sortie (RF') du mélangeur est transmise à un mélangeur inverse (M3), par le fait que du signal ayant subi le mélange inverse on extrait par filtrage la fréquence intermédiaire ainsi qu'au moins un multiple de celle-ci en tant que mesure pour la suppression d'oscillateur et de bande latérale, et par le fait qu'à partir de ces signaux extraits par filtrage on acquiert les signaux de commande ($V_{B1}$, $V_{B2}$) pour les étages mélangeurs (M1, M2).

**2.** Procédé selon revendication 1, caractérisé par le fait qu'à partir de la fréquence intermédiaire résultant du mélange inverse, extraite par filtrage, ainsi qu'à partir de la fréquence intermédiaire doublée extraite par filtrage, on acquiert des signaux de commande ($V_a$, $V_\phi$)pour un déphaseur pouvant être commandé (Ph) et pour un élément d'atténuation pouvant être commandé (Dg) dans le circuit de fréquence intermédiaire du mélangeur élévateur.

3. Procédé selon revendication 1 ou 2, caractérisé par le fait que les tensions de commande ($V_{B1}$, $V_{B2}$, $V_a$, $V_\phi$) sont acquises au moyen d'un microcalculateur (MC) à partir des signaux ayant subi le mélange inverse et extraits par filtrage.

4. Procédé selon l'une des revendications 1 à 3, caractérisé par le fait que, pour sélectionner la bande latérale à supprimer, la fréquence à convertir (IF) est introduite dans le circuit de fréquence intermédiaire par un circuit en pont à diodes Pin (PD).

5. Agencement de mise en oeuvre du procédé selon l'une des revendications 1 à 4 pour la régulation d'un mélangeur élévateur à bande latérale unique, constitué par deux étages mélangeurs (M1, M2) et par des moyens pour appliquer la fréquence à convertir (IF) et la fréquence d'oscillateur (LO), caractérisé par le fait que des moyens d'extraction par couplage (C4) sont prévus à la sortie du mélangeur, par le fait que ces moyens d'extraction par couplage (C4) sont reliés à un mélangeur inverse (M3), par le fait que la sortie du mélangeur inverse (M3) est reliée à des filtres (F1, F2) pour la fréquence intermédiaire (IF) ainsi que pour la fréquence intermédiaire doublée (2xIF), par le fait que ces filtres (F1, F2) sont suivis de moyens redresseurs (G1, G2) par le fait que les sorties des moyens redresseurs vont à un microcalculateur (MC), par le fait que des sorties du microcalculateur (MC) vont à des entrées de commande des étages mélangeurs (M1, M2) et à des entrées de commande d'au moins un déphaseur pouvant être commandé (Ph) et/ou d'un élément d'atténuation (Dg) dans le circuit de fréquence intermédiaire du mélangeur élévateur.

FIG. 1

FIG. 2

FIG. 3

FIG.4

FIG.5

FIG.6

FIG.7

FIG.8